# EUROPEAN PATENT APPLICATION

(11) **EP 1 294 015 A1**
(43) Date of publication of application: **19.03.2003**
(21) Application number: 01121940.9
(22) Date of filing: 12.09.2001
(51) Int. Cl.: H01L 21/28, H01L 21/321

(54) **Method for patterning a conductive polycrystalline layer**

(71) Applicant: Infineon Technologies AG, 81669 München (DE)
(72) Inventor: Cappellani, Annalisa, 96100 Siracusa (IT)
(74) Representative: Ginzel, Christian

(57) **Abstract**

A conductive polycrystalline layer having a rough surface is deposited onto a substrate and subsequently polished to reduce the roughness of the surface of the deposited polycrystalline conductive layer. The polished layer is etched using a mask formed on the polished surface, of the conductive polycrystalline layer. Due to the polished surface the conductive polycrystalline layer is etched more evenly which reduces the risk of an unwanted etching of the underlying substrate.

## Description

The present invention relates to the formation of patterned conductive polycrystalline layers, and in particular to the formation of metal gate and poly-metal gate electrode structures for Metal Oxide Semiconductor Field Effect Transistors (MOSFETs).

Dry etching of polycrystalline materials (e.g. polysilicon, metals, etc.) is a very common technique in semiconductor device fabrication. For example, metal dry etching is necessary for patterning metal and poly-metal gates in connection with CMOS and DRAM applications as for instance described in US 6,133,150 and US 6,197,702.

The dry etching of a layer generally comprises the steps of forming a mask having a predetermined pattern on the polycrystalline material to be etched, exposing the masked layer to an etch gas which etches the polycrystalline material selectively with regard to the material of the mask, to transfer the pattern of the mask onto the polycrystalline material, and removing the mask. Another important point besides the selectivity of the etching gas is that the etching should stop at the substrate underlying the polycrystalline material. It is often not desired that the underlying substrate (or underlying layer) is etched or partially etched as well. For example, the etching of a gate electrode should stop on the underlying gate oxide layer. In other words, the etching gas should also etch the polycrystalline material selectively with regard to the underlying substrate or layer. The latter point becomes even more important in the case of a thin underlying layer such as a gate oxide layer.

The Inventor has observed, that for instance during the etching of the gate electrode layer, the underlying gate oxide layer is at least partially removed as well. Since the etch chemistry that is used to etch the gate also etches the silicon substrate, the removal of the gate oxide layer often leads to substantial damage to the source/drain regions of the transistors.

Through a thorough analysis the Inventor came to the conclusion that the method which is used to deposit the polycrystalline material has an important influence on the partial etching of the gate oxide layer. For instance, if the polycrystalline material is deposited by using a chemical vapour deposition (CVD), the risk of damage to the underlying gate oxide layer is much higher than in the case when a physical vapour deposition (PVD) method is used. Moreover, the surface of the underlying substrate or layer, after the etching of the polycrystalline material, appears more even in the case of PVD deposited polycrystalline material.

A CVD method uses reactant gases which flow over the substrate onto which the polycrystalline material is to be deposited. The reactant gases (often called precursors) will react with each other when they come in contact with the surface. One reaction product is the polycrystalline material which remains on the surface and forms the deposited layer. The other reaction products are gases which escape from the surface. In contrast to this, a PVD method does not require any reactant gases; the polycrystalline material is basically sputtered onto the surface. Sputtering means that a sputter target of the desired material is exposed to an ion bombardment which knocks out atoms from the target. These atoms are then deposited onto the surface of the corresponding substrate. In both cases a polycrystalline layer is formed.

A further analysis revealed that the difference in the etching behaviour of PVD films and CVD films can be related to the roughness of the deposited polycrystalline material. For instance, tungsten layers deposited by a CVD method show a very high roughness in contrast to PVD deposited tungsten layers. The roughness results from the grain size of the polycrystalline material which in turn depends on the deposition conditions. The grain size also depends on the roughness of the underlying surface upon which the polycrystalline material is to be deposited.

At the very beginning of a CVD deposition process the deposited atoms of the polycrystalline material diffuse on the surface until they form small islands. The diffusion rate and hence the size of these islands depends for instance on the surface tension, the temperature of the surface, and the deposition rate. As the deposition process progresses, more material (atoms) reaches the surface and diffuses to the already formed islands or forms new islands. The size of the islands increases and grains are formed. In addition, islands or grains which are in contact with each other may fuse to form even larger grains. Finally, the growth of the grains stops when no more deposited material can diffuse to the grains. As a result the deposited polycrystalline material shows a characteristic mean grain size.

If the thickness of the deposited layer is much larger than the mean grain size, the granularity of the material is of less influence on the performance of subsequent etching steps. If, however, the thickness of the deposited layer is scaled down towards the grain size, the influence of the granularity on the etch performance increases.

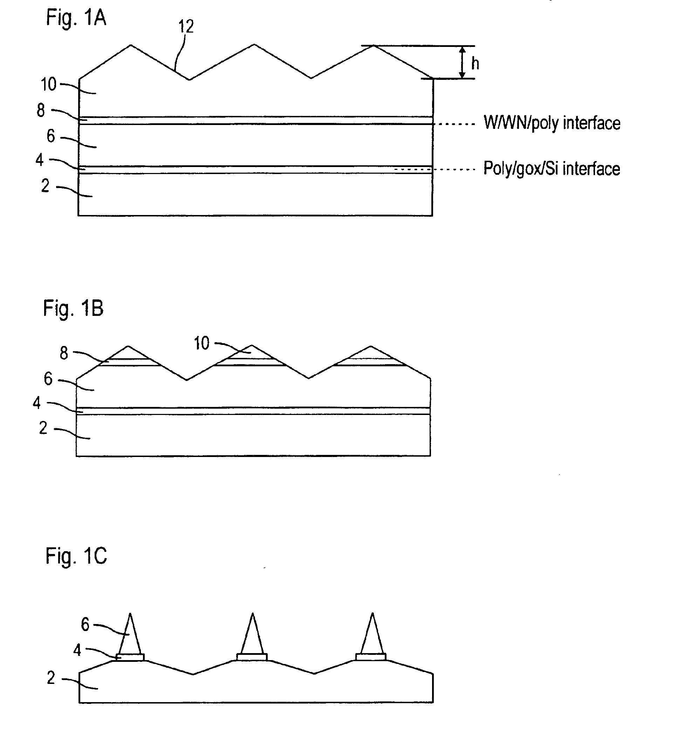

The influence of the granularity becomes even more pronounced if the etch selectivity between the polycrystalline material and the underlying substrate is not very high. This problem shall be explained in more detail with the help of figures 1A to 1C which show the etching steps used to form a poly-metal gate electrode structure. Obviously, the etching steps represent only a portion of a bigger process sequence used to form a poly-metal gate electrode structure. Thereby, the deposition of the poly-metal gate material by a CVD method is for instance described in US 6,187,656.

In order to complete the formation of a gate electrode structure, the deposited layers are structured by an etching process. Figure 1A shows a silicon substrate 2 covered by a thin gate oxide layer 4. A polysilicon layer 6 resides upon the gate oxide layer 4. A tungsten nitride layer 8 and a tungsten layer 10 cover the polysilicon layer 6. The tungsten layer 10 is deposited by a CVD method. As indicated in Figure 1A, the tungsten layer 10 has a rough surface 12. The height h describes the maximum difference between the highest and lowest point of the rough surface (so called Z-range). Figures 1A to 1C show only the areas outside the gate electrode structure which are to be removed by etching.

In a subsequent step, the tungsten layer 10 and the tungsten nitride layer 8 are etched using HCl/Cl/NF₃ as etch gases. The two layers are etched in the same etch step using the same etch chemistry. Thereby, the etch rate depends on the grain orientation, since the etch rate is higher along the grain boundaries.

Moreover, those areas of the tungsten layer which are thicker (illustrated by the peaks) than other areas need more time to be etched. As a consequence, the tungsten layer is already removed in certain areas, while other areas are still covered. Since the etching proceeds to remove most or all of the tungsten/tungsten nitride layer, the etch gases also affect the underlying polysilicon layer in the uncovered areas and, if the etch selectivity is not very high, tend to etch the polysilicon layer as well. If, on the other hand, the etching is not carried out until every tungsten and tungsten nitride is removed, some tungsten /tungsten nitride remains on the polysilicon layer. This remaining material will act as a local mask (micro-masking) during the subsequent etching of polysilicon.

The duration of the etching can be controlled either by the so called end-point detection, or by a predetermined fixed etch time. The latter is a result of the experience of the operator which controls the etching. In contrast to this, end-point detection uses a change of an emission signal of the etch plasma which occurs when the etch gas comes in contact with the underlying layer (e.g. polysilicon).

However, in both cases one has to stop the etching before the tungsten/tungsten nitride is completely removed in order to prevent the etching of the underlying layer to a larger degree. Therefore, if the tungsten/tungsten nitride layer is unevenly etched due its rough surface as explained above, some tungsten/tungsten nitride will remain as micro-masks on the polysilicon layer. Moreover, the unmasked portion of the polysilicon layer may already be etched to a certain degree. The partially-etched polysilicon layer covered by micro-masking tungsten and tungsten nitride is shown in Figure 1B.

As shown in Figure 1C, the polysilicon layer is removed in a subsequent step. However, due to the partially-remaining tungsten/tungsten nitride, the polysilicon is not completely removed. Some spikes still remain. On the other hand, in those areas in which the polysilicon was already etched during the tungsten/tungsten nitride etching step, the underlying gate oxide layer 4 may be removed due to an overetch.

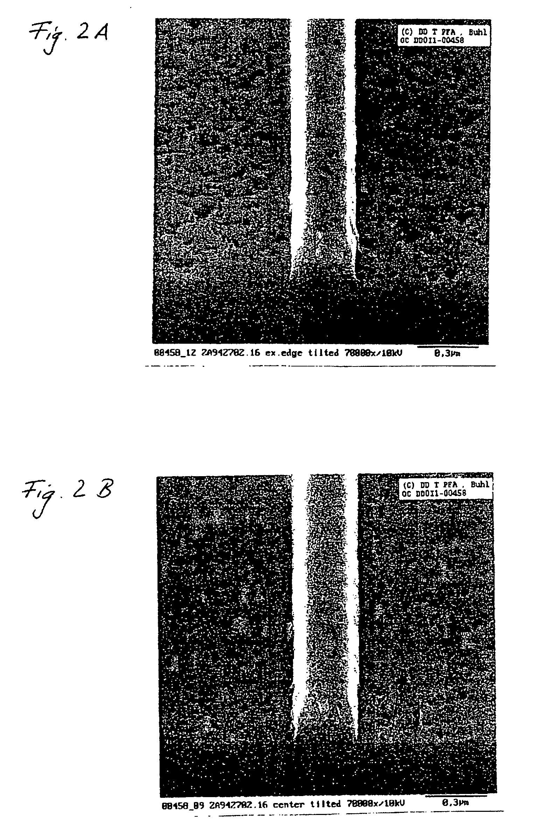

Figures 2A and 2B show REM photographs illustrating the gate electrode structure and the exposed gate oxide layer. Fig. 2A is a top view of the structured gate in the middle and corresponding source/drain areas on the left and on the right side of the gate. As can clearly be seen, the gate oxide layer is already removed in some areas (holes), so that the etch gases used to etch the gate are able to etch the bulk silicon below the gate oxide layer.

Fig. 2B shows a similar structure as Fig. 2A. However, the structure shown in Fig. 2B is located closer to the centre of the wafer where the etch rate is generally lower. Accordingly, more spikes made of tungsten/tungsten nitride/polysilicon are left on the gate oxide layer.

The effect of an uneven etching of the underlying layer becomes more pronounced if the underlying layer is thin and the etch selectivity is not very high. In the above described example, the etch selectivity between the tungsten and polysilicon or tungsten and silicon oxide (if a metal gate of tungsten directly resides upon a gate oxide layer is considered) is not sufficiently high to prevent the damage of the thin gate oxide layer.

In order to solve the problem, a PVD deposition method could be used which would lead to a smoother surface of the deposited polycrystalline material. As revealed by the Inventor of the present invention, tungsten layers deposited by physical vapour deposition (PVD) show a very smooth surface. PVD methods are widely used to form gate electrode structures as described in US 6,133,150 and US 6,197,702. However, PVD methods exhibit a serious drawback. Since PVD methods employ high ion bombardment during the layer deposition, layers or structures which are already present on the surface of the substrate onto which the PVD layer is to be deposited, are also exposed to the high ion bombarding. In particular, thin gate oxide layers (≤ 4,5 nm thick) tend to degrade or are partially removed.

Another possibility to overcome the above mentioned problem is to increase the etch selectivity. However, this requires a new etch chemistry which might not be compatible with the existing standard production environment.

It is therefore an object of the invention to provide a method for patterning a conductive polycrystalline layer which has a reduced impact on the underlying layers and which can be easily performed.

The present invention provides an improved method for patterning a conductive polycrystalline layer. According to one aspect of the present invention, there is provided a method for patterning a conductive polycrystalline layer as specified in independent claim 1. According to a further aspect of the present invention, there is provided a method for forming a poly-metal gate electrode structure as specified in independent claim 8. Further advantages, features, aspects and details of the invention are evident from the dependent claims, the description and the accompanying drawings. The claims are intended to be understood as a first non-limiting approach of defining the invention in general terms.

According to one aspect of the present invention, a method for patterning a conductive polycrystalline layer is provided which comprises the steps of:
a) depositing at least one conductive polycrystalline layer onto a substrate, said conductive polycrystalline layer having a surface with a given roughness,
b) polishing said surface of said conductive polycrystalline layer to reduce the roughness of said surface by a given degree,
c) depositing a mask layer onto said conductive polycrystalline layer, and
d) etching said conductive polycrystalline layer using said mask layer as an etching mask to pattern said conductive polycrystalline layer.

According to a further aspect of the present invention, a method for forming a poly-metal gate electrode structure is provided which comprises the steps of:
a) depositing a polysilicon layer onto a substrate,
b) depositing at least one conductive polycrystalline layer essentially made of a metal onto said polysilicon layer, said conductive polycrystalline layer having a surface with a given roughness,
c) polishing said surface of said conductive polycrystalline layer to reduce the roughness of said surface by a given degree,
d) depositing a mask layer onto said conductive polycrystalline layer,
e) etching said conductive polycrystalline layer using said mask layer as an etching mask, and
f) etching said polysilicon layer, so that said etched conductive polycrystalline layer and said etched polysilicon layer form a poly-metal gate electrode structure.

According to the invention, the surface of the conductive polycrystalline layer is polished before etching. The polishing reduces the roughness by a given degree such that a smoother surface of the conductive polycrystalline layer is obtained which can be evenly etched, hence, the risk of an unwanted etching of the underlying layer is reduced. Another advantage of the invention is that the standard etch chemistry can be used.

The polishing of deposited material is used in prior art either to planarise the surface of the deposited material or to structure it. With the planarisation, a macroscopic flat surface for the deposition of a further layer is aimed for, as for instance described in US 6,133,115. On the other hand, structuring by polishing (so called damascene structuring) means that the deposited material is deposited onto a pre-patterned surface and subsequently polished back, leaving deposited material only within the trenches of the pattern (see for instance US 6,221,704). In both cases a substantial amount of material is removed. Furthermore, the polishing stops on raised structures which are coplanar with the polished material. Hence, the deposited material is completely removed in certain areas.

In contrast to this, the polishing step of the present invention only reduces the microscopic roughness of the surface of the deposited conductive polycrystalline material by a given degree. This means that the back-polishing only leads to a removal of material of the conductive polycrystalline layer in an amount which is substantially less than the total amount of material in the layer itself. The surface of the conductive polycrystalline layer becomes smooth, and for example the maximum variation of the height h (expressed as Z-range) in the microscopic scale decreases. The polishing may lead to a reduction of the thickness of the conductive polycrystalline layer. Preferably, the reduction of the thickness is small in comparison with the thickness of the conductive polycrystalline layer.

In a preferred embodiment of the present invention the roughness of the deposited conductive polycrystalline layer is reduced by at least 50%, preferably by at least 90%. Thereby, the roughness of the deposited conductive polycrystalline layer can be characterised by various parameters such as the maximum variation of the height h (expressed as Z-range) or the so called roughness value R, which is given as the standard deviation of the Z-range.

In a further preferred embodiment of the present invention the polishing is performed by chemical mechanical polishing. It is further preferred that the conductive polycrystalline layer is deposited by chemical vapour deposition. In particular, the patterning of a conductive polycrystalline layer essentially made of a metal can be improved using the inventive method. The metal can be a refractory metal such as tungsten.

The inventive method can be used to form a metal gate electrode structure, wherein the patterned conductive polycrystalline layer forms the gate electrode. The conductive polycrystalline layer, e.g. made out of tungsten, is deposited upon a gate oxide layer and subsequently etched according to the invention without damaging the thin gate oxide layer.

As outlined with regard to the second aspect of the present invention, the inventive method may also be used for forming a poly-metal gate electrode structure. In this respect it is preferred that between said step a) and said step b) a metal nitride layer is deposited onto said polysilicon layer. Thereby, it is especially preferred, if said metal nitride layer is a tungsten nitride layer.

Furthermore, it is preferred, if before said step a) a dielectric layer used to form a gate oxide layer is deposited onto said substrate and said polysilicon layer is deposited onto said dielectric layer.

The invention will now be described in more detail with the help of the figures which show:
- Figures 1A to 1C: a method for patterning a conductive polycrystalline layer according to the prior art,
- Figures 2A and 2B: REM photographs of a gate electrode structure formed according to the prior art,
- Figures 3A to 3C: measurements of the roughness of tungsten layers deposited by CVD, REM photograph, and
- Figures 4A to 4D: an embodiment of the method according to the present invention.

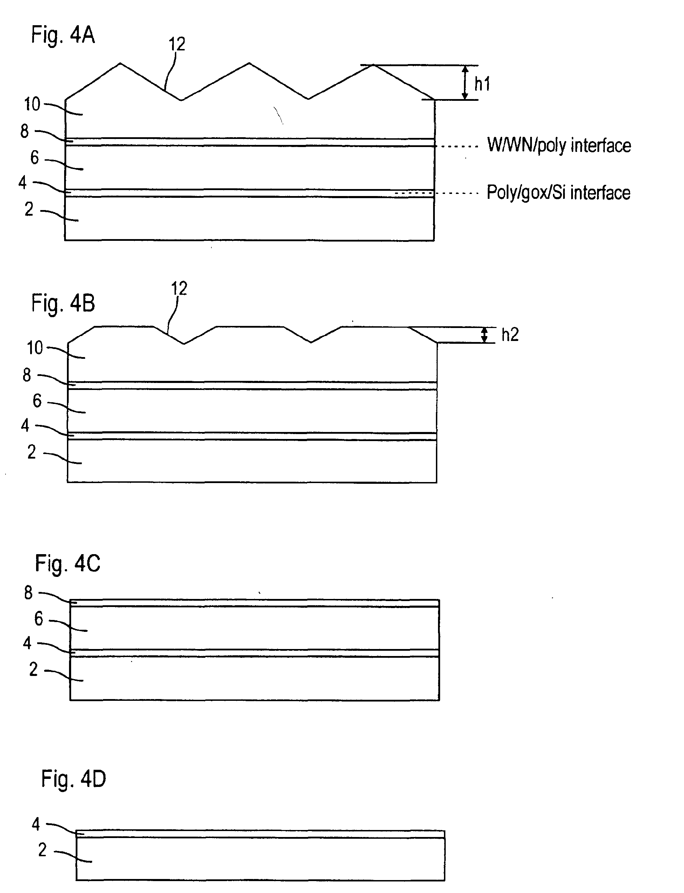

The invention will be described with regard to the Figures 4A to 4D showing a method to form a poly-metal gate electrode structure. However, the inventive method is not restricted thereto.

As shown in Figure 4A, a polysilicon layer 6 of about 100 nm is deposited upon a gate oxide layer 4 which resides on a silicon substrate 2. Next, a tungsten nitride layer 8 and a tungsten layer 10 are deposited by a CVD method using WF₆ and NH₃ as source material for tungsten nitride layer and WF₆ and SiH₄ as source material for tungsten layer. In this embodiment, the tungsten layer represents the conductive polycrystalline layer.

In this example, the gate oxide layer 4 which is preferably made of silicon dioxide, is about 4.5 nm thick. The thickness of the tungsten nitride layer may vary between 4 and 10 nm.

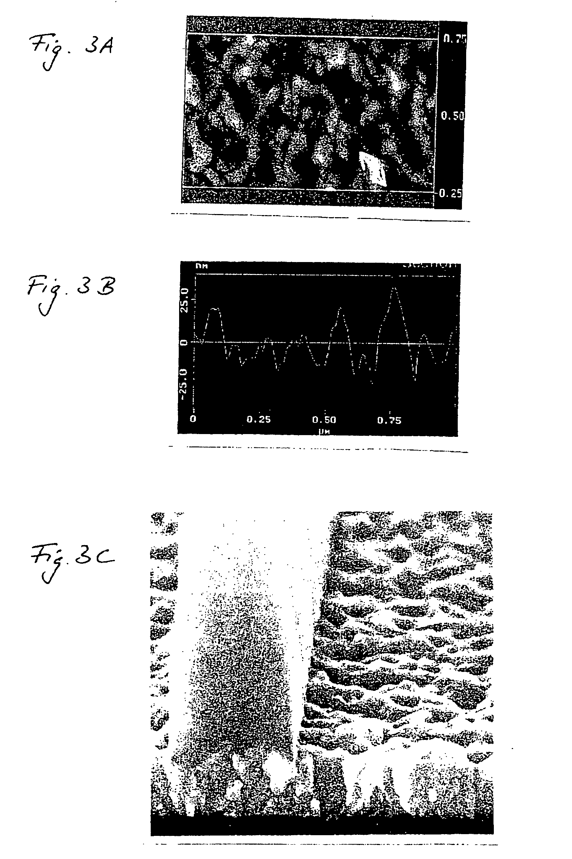

After the deposition the surface of the tungsten layer 10 is rough as indicated by the parameter h1, which illustrates the maximum variation of the height of the surface of the tungsten layer 10. The height profile can be measured for instance by Atomic Force Microscopy (AFM), as shown in Figures 3A and 3B. Figure 3A shows a photograph of a tungsten surface taken by AFM. The maximum observed grain size was about 150 nm whereas the mean thickness of the tungsten layer was 161 nm. This means that in this example the grain size is of the same order as the thickness of the layer. Figure 3B shows a scan of the surface of the tungsten layer 10 along a line. The maximum variation of the surface (h1 or Z-rang) measured was 58 nm. Figure 3C gives an even better impression of the roughness of the tungsten layer. Figure 3C shows a REM photograph of a tungsten layer partially covered by a resist layer.

In a subsequent step, a chemical mechanical polishing is performed to reduce the roughness of the conductive polycrystalline layer 10. This is schematically shown in Figure 4B. The roughness of the surface 12 of the polished conductive polycrystalline layer 10 is indicated by the parameter h2 which is considerably smaller than h1. In the case of tungsten as material for the conductive polycrystalline layer, a so called "CMP Touch Up" is performed using the commercially available slurry "Klebosol" (manufactured by Clariant) which comprises small SiO₂ particles (50 nm) as abrasives and NH₃ as a stabiliser. The pH value of the slurry is 10.

The polishing step reduces the roughness of the conductive polycrystalline layer from the initial values z-range = 58 and roughness value R = 8,8 before the CMP procedure to the final values z-range = 20 and roughness value R = 2,1 after 2 minutes of polishing. After 4 minutes of polishing, final values z-range = 5 and roughness value R = 0,5 can be reached. These values are comparable to the roughness values of layers that are deposited using a PVD method.

Further information about the polishing step can be drawn from table 1 in which the roughness of tungsten layers of different test wafers are compared before and after CMP. Thereby, the duration of the CMP step and the thickness of the tungsten layer was varied to study the influence on the roughness. Table 1 contains the Sample ID number (Wafer #), details of the deposition method (for example CVD 10/150 on poly stands for 10 nm WN and 150 W layers deposited on a polycristalline substrate using a CVD method), the grain size, the z-range, the roughness value R, the thickness of the tungsten layer as measured according to certain measurement tool and calibration recipe (Rigaku WQUAD (WPOL)), the duration of the CMP polishing, and the polishing rate. Table 1 clearly shows that even a short CMP step can lead to a considerable reduction of the surface roughness for CVD deposited polycrystalline layer.

Due to the reduced roughness of the surface of the conductive polycrystalline layer 10, the etching of the conductive polycrystalline layer 10 performs more evenly, hence, the risk of damage to the underlying polysilicon layer is reduced. Furthermore, the etching of the conductive polycrystalline layer 10 can be done in a manner so that the conductive polycrystalline layer 10 is completely removed from the tungsten nitride layer 8 or, if the tungsten layer 10 and the tungsten nitride layer 8 are etched in the same etch step, from the polysilicon layer 6 (Fig. 4C). Accordingly, no micro-masking could be observed.

As a last step, the polysilicon layer 6 is etched so that the etched conductive polycrystalline layer and the etched polysilicon layer form a poly-metal gate electrode structure (not shown). Due to the fact that the method according to the present invention basically avoids micro-masking and a partial etching of polysilicon layer 6 during the etching of the tungsten layer 10, an unwanted removal of gate oxide layer 4 is avoided (Fig. 4D). Accordingly, the integrity of the gate oxide layer 4 is maintained so that an unwanted etching of silicon substrate 2 can be prevented.

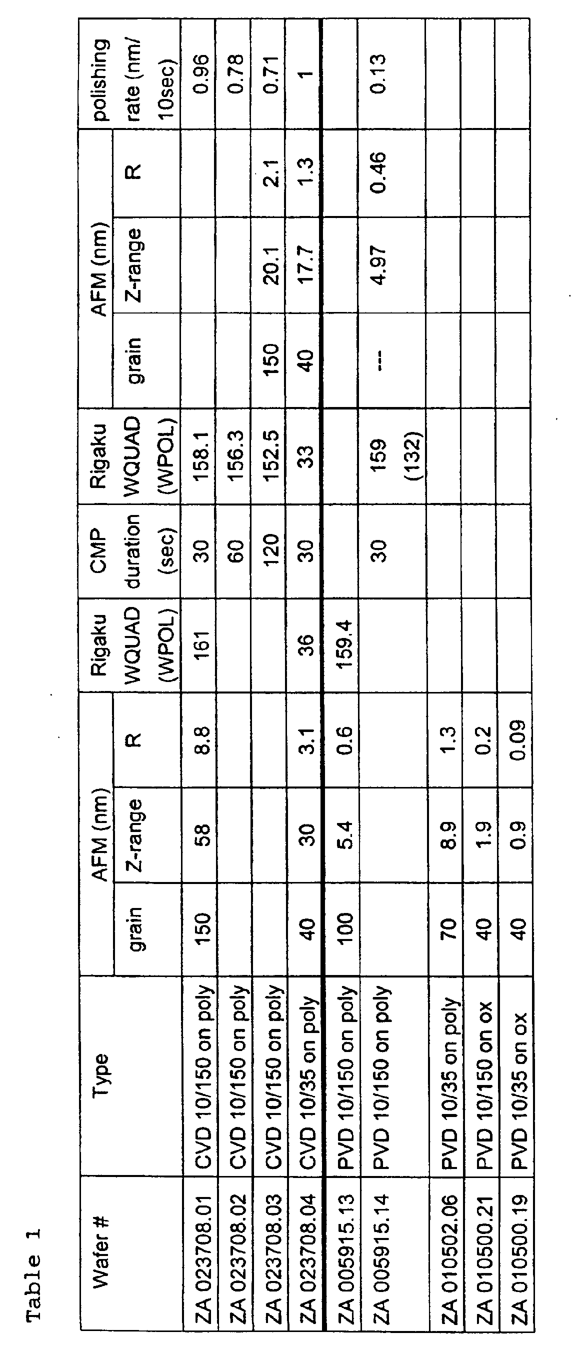

## Claims

1. A method for patterning a conductive polycrystalline layer comprising the steps of:
a) depositing at least one conductive polycrystalline layer onto a substrate, said conductive polycrystalline layer having a surface with a given roughness,
b) polishing said surface of said conductive polycrystalline layer to reduce the roughness of said surface by a given degree,
c) depositing a mask layer onto said conductive polycrystalline layer, and
d) etching said conductive polycrystalline layer using said mask layer as an etching mask to pattern said conductive polycrystalline layer.

2. A method as set forth in claim 1, wherein
said step b) is performed by chemical mechanical polishing.

3. A method as set forth in claim 1 or 2, wherein
said conductive polycrystalline layer is deposited by chemical vapour deposition.

4. A method as set forth in one of claims 1 to 3, wherein said conductive polycrystalline layer is essentially made of a metal.

5. A method as set forth in claim 4, wherein
said metal of said conductive polycrystalline layer is a refractory metal, especially tungsten.

6. A method as set forth in claim 4 or 5, wherein
said patterned conductive polycrystalline layer forms a metal gate electrode structure.

7. A method as set forth in one of claims 1 to 6, wherein the roughness of said surface is reduced by at least 50%, preferably by at least 90%.

8. A method for forming a poly-metal gate electrode structure comprising the steps of:
a) depositing a polysilicon layer onto a substrate,
b) depositing at least one conductive polycrystalline layer essentially made of a metal onto said polysilicon layer, said conductive polycrystalline layer having a surface with a given roughness,
c) polishing said surface of said conductive polycrystalline layer to reduce the roughness of said surface by a given degree,
d) depositing a mask layer onto said conductive polycrystalline layer,
e) etching said conductive polycrystalline layer using said mask layer as an etching mask, and
f) etching said polysilicon layer, so that said etched conductive polycrystalline layer and said etched polysilicon layer form a poly-metal gate electrode structure.

9. A method as set forth in claim 8, wherein
said step c) is performed by chemical mechanical polishing.

10. A method as set forth in claim 8 or 9, wherein
said conductive polycrystalline layer is deposited by chemical vapour deposition.

11. A method as set forth in one of claims 8 to 10, wherein
said metal of said conductive polycrystalline layer is a refractory metal, especially tungsten.

12. A method as set forth in one of claims 8 to 11, wherein
the roughness of said surface is reduced by at least 50%, preferably by at least 90%.

13. A method as set forth in one of claims 8 to 12, wherein
between said step a) and said step b) a metal nitride layer is deposited onto said polysilicon layer.

14. A method as set forth in claim 13, wherein
said metal nitride layer is a tungsten nitride layer.

15. A method as set forth in one of claims 8 to 14, wherein
before said step a) a dielectric layer used to form a gate oxide layer is deposited onto said substrate and said polysilicon layer is deposited onto said dielectric layer.
